# EUROPEAN PATENT SPECIFICATION

(11) **EP 1 728 893 B1**
(45) Date of publication and mention of the grant of the patent: **13.04.2011**
(21) Application number: 06010939.4
(22) Date of filing: 26.05.2006
(51) Int. Cl.: C23C 16/40, C23C 16/455, C23C 16/46

(54) **Process for forming zinc oxide film**
Verfahren zur Herstellung einer ZnO-Schicht
Procédé de préparation d'une couche de ZnO

(30) Priority: 01.06.2005 JP 2005161187
(43) Date of publication of application: 06.12.2006
(73) Proprietor: Japan Pionics Co., Ltd., Minato-ku Tokyo (JP)
(72) Inventor: Takamatsu, Yukichi c/o Japan Pionics Co., Ltd., Tokyo 105 (JP); Akiyama, Toshio c/o Japan Pionics Co., Ltd., Hiratsuka-shi Kanagawa (JP)
(74) Representative: Leifert & Steffan

(56) References cited:
- US-A1- 2003 031 787
- SATO H ET AL: "LOW TEMPERATURE PREPARATION OF TRANSPARENT CONDUCTING ZNO:AL THIN FILMS BY CHEMICAL BEAM DEPOSITION" THIN SOLID FILMS, ELSEVIER-SEQUOIA S.A. LAUSANNE, CH, vol. 236, no. 1/2, 15 December 1993 (1993-12-15), pages 14-19, XP000415508 ISSN: 0040-6090
- GORDON R G: "DEPOSITION OF TRANSPARENT CONDUCTING OXIDES FOR SOLAR CELLS" AIP CONFERENCE PROCEEDINGS, AMERICAN INSTITUTE OF PHYSICS, NEW YORK,NY, US, 1997, pages 39-48, XP000749515 ISSN: 0094-243X
- POLLEY T A ET AL: "Deposition of zinc oxide thin films by combustion CVD" THIN SOLID FILMS, ELSEVIER-SEQUOIA S.A. LAUSANNE, CH, vol. 357, no. 2, 15 December 1999 (1999-12-15), pages 132-136, XP004244611 ISSN: 0040-6090

## Description

### TECHNICAL FIELD

The present invention relates to a process for forming zinc oxide film. Particularly, the present invention relates to a process for forming zinc oxide film on surfaces of various kinds of substrates safely and easily in accordance with a chemical vapor deposition (CVD) method with a use of a material prepared by dissolving dimethylzinc or diethylzinc into an organic solvent, or supplying vaporized gas of dimethylzinc or diethylzinc and oxidizing agent gas into a CVD apparatus alternately.

### BACKGROUND ART

Conventionally, zinc oxide is widely employed as a substance for forming an insulation film, a transparent electrode film or a semiconductor film over the surfaces of various substrates. Other than the use, for example, as a component of transparent electrode film such as a plasma display panel, solar battery and so on, the zinc oxide film is proposed to be employed as a material film for a photoelectronic element as an alternative to a gallium nitride based light emitting diode.

Regarding with general processes for forming zinc oxide films, for example, a process for forming the zinc oxide film over a surface of a substrate in accordance with a sputtering process under an atmosphere of argon gas, or under an existence of argon gas and oxygen gas, with the use of zinc and zinc oxide as target materials was widely employed. Further, a process for forming zinc oxide film in accordance with a sol-gel method was also utilized.

For example, Japanese Unexamined Patent Application Laid-Open No. 2001-210867 discloses a process for forming zinc oxide film over P-type gallium nitride semiconductor layer in the gallium nitride based semiconductor light emitting element in accordance with vacuum vapor deposition process, laser ablation process or sol-gel process. Further, Japanese Unexamined Patent Application Laid-Open No. 2003-105559 discloses a process for producing a blue luminescent article comprising zinc oxide film which consists of a step of forming the zinc oxide film with an addition of a dopant over a substrate, a step of entering the substrate into a heat treatment apparatus and a step of heat treatment under an atmosphere of a predetermined gas in the heat treatment apparatus. Furthermore, Japanese Unexamined Patent Application Laid-Open No. 2004-323941 discloses a process for forming a zinc oxide film employed to a front screen for plasma display panel, low radiation glass sheet or so in accordance with a magnetron sputtering process.

Sato et al. describes in "Thin Solid Films", 236 (1993) 14-19 the "Low temperature preparation of transparent conducting ZnO : Al thin films by chemical beam deposition". In Fig. 2 of said publication the preparation of a ZnO film by alternately switching the injection of diethylzinc and water as source gases is disclosed.

Moreover, a process for forming zinc oxide film on surfaces of substrates in accordance with a CVD method after vaporizing a liquid material prepared by dissolving a solid material such as zinc acetate [Zn(CH₃COO)₂], zinc (II) acetylacetonate [Zn(CH₃CO)₂CH], bis (2,2,6,6,-tetramethyl-3,5 heptanegeonite) zinc [Zn(DPM)₂] into an organic solvent of tetrahydrofuran or so is conceivable.

### DISCLOSURE OF THE INVENTION

When the zinc oxide film is formed over the substrate in accordance with the CVD method, it is technically more difficult than either the zinc oxide film formation in accordance with a sputtering process or the zinc oxide film formation in accordance with a sol-gel process. It is difficult for the CVD method to supply a material of a homogeneous composition to the surface of the substrate because the foregoing solid materials have vaporizing temperature significantly different from that of the solvent, and only the solvent easily vaporizes with heating resultantly causing to precipitate the solid material. Further, although employing a liquid material of dimethylzinc, diethylzinc or so as the material is conceivable, it was extremely difficult to handle because dimethylzinc particularly has a chemical property of igniting in the air, exploding in the oxygen.

Despite the difficulty, the zinc oxide film formed in accordance with the CVD method is still desired to be practical because the zinc oxide film with CVD method is expected to provide higher quality and higher purity than the zinc oxide film formed in accordance with a sputtering process or a sol-gel process. Particularly, when the zinc oxide film is employed for photo-electronics devices, those having a crystal of extremely high quality are demanded.

Therefore, an object of the present invention is to provide a process for forming zinc oxide film of extremely high quality and high purity on surfaces of various kinds of substrates safely in accordance with the CVD method.

As a result of intensive extensive research and investigation made by the present inventors in order to achieve the object, it has been found that employing dimethylzinc or diethylzinc as the material enables to form the zinc oxide film of higher quality and higher purity than employing solid materials such as zinc acetate, zinc (II) acetylacetonate, bis (2,2,6,6,-tetramethyl-3,5 heptanedionite) zinc. Further, it has been found that dissolving dimethylzinc or diethylzinc into an organic solvent such as hydrocarbons or so, or supplying a vaporized gas of dimethylzinc or diethylzinc and an oxidizing agent gas such as oxygen alternately into a CVD apparatus enables to form the zinc oxide film safely in accordance with the CVD method; and the present invention was completed.

Namely, the present invention provides a process for forming zinc oxide film over a surface of a substrate which comprises a step of vaporizing and supplying a material prepared by dissolving dimethylzinc or diethylzinc into an organic solvent to a chemical vapor deposition apparatus and a step of simultaneously supplying a gas comprising an oxidizing agent gas to the chemical vapor deposition apparatus.

### BRIEF DESCRIPTIONOF THE DRAWINGS

FIG. 1 is a schematic structure illustrating one embodiment of an apparatus for vaporizing and supplying in relation to the present invention;
FIG. 2 is a schematic structure illustrating one embodiment of a vaporizer employed in relation to the present invention; and
FIG. 3 is a schematic structure illustrating one embodiment of a chemical vapor deposition apparatus employed in the present invention.

### PREFERRED EMBODIMENT TO CARRY OUT THE INVENTION

The present invention provides a process for forming zinc oxide film over a surface of a substrate which comprises a step of vaporizing and supplying a material prepared by dissolving dimethylzinc or diethylzinc into an organic solvent to a chemical vapor deposition apparatus and a step of simultaneously supplying a gas comprising an oxidizing agent gas to the chemical vapor deposition apparatus.

The process for forming zinc oxide film of the present invention is applicable for forming zinc oxide film over various substrates. When the zinc oxide film is formed over a silicon substrate, a sapphire substrate or so particularly for a photo-electronics device, the present invention is effective in a viewpoint of obtaining a crystal of extremely high quality.

The present invention aims to improve safety by dissolving dimethylzinc or diethylzinc into an organic solvent and diluting the mixture.

The material employed in the invention is a solution prepared by dissolving dimethylzinc or diethylzinc into an organic solvent such as ether, ketone, ester, alcohol, hydrocarbon, etc.

Examples of the above ether include propyl ether, methylbutyl ether, ethyl propyl ether, ethyl butyl ether, trimethylene oxide, tetrahydrofuran, tetrahydropyran, etc. Examples of the above ketone include acetone, ethyl methyl ketone, iso-propyl methyl ketone, iso-butyl methyl ketone, etc. Examples of the above ester include ethyl formate, propyl formate, isobutyl formate, methyl acetate, ethyl acetate, propyl acetate, butyl acetate, isobutyl acetate, methyl propionate, propyl propionate, methyl butyrate, ethyl butyrate, etc. Examples of the above alcohol include methyl alcohol, ethyl alcohol, propyl alcohol, butyl alcohol, etc. Examples of the above hydrocarbon include hexane, heptane, octane, nonane, decane, cyclohexane, cycloheptane, cyclooctane, cyclononane, cyclodecane, etc.

Among the foregoing organic solvent, a paraffinic hydrocarbon expressed with general formula CₙH₂ₙ₊₂ or cycloparaffinic hydrocarbon expressed with general formula CₙH₂ₙ (n: about 5 to 12) is preferable; and further, hexane, heptane and octane are particularly preferable.

Further, the content of dimethylzinc or diethylzinc in the material is usually 0.1 to 5.0 mol/liter and preferably 0.5 to 2.0 mol/liter. When the content of dimethylzinc or diethylzinc in the material is less than 0.1 mol/liter, a disadvantage occurs that a forming rate of the zinc oxide film becomes slow. When the content exceeds 5.0 mol/liter, an anxiety occurs that a safe manipulation of the material, a safe vaporization and supplying of the material and a safe formation of the zinc oxide film become difficult.

The material prepared by mixing dimethylzinc or diethylzinc with the organic solvent is usually being prepared easily and is stable at around a room temperature (0 to 40 °C), under an ordinary pressure or its adjacent pressure (80 to 120 kPa) and among an atmospheric inert gas. Further, even if the material came into contact with air or oxygen by any chance, it should never ignite or explode.

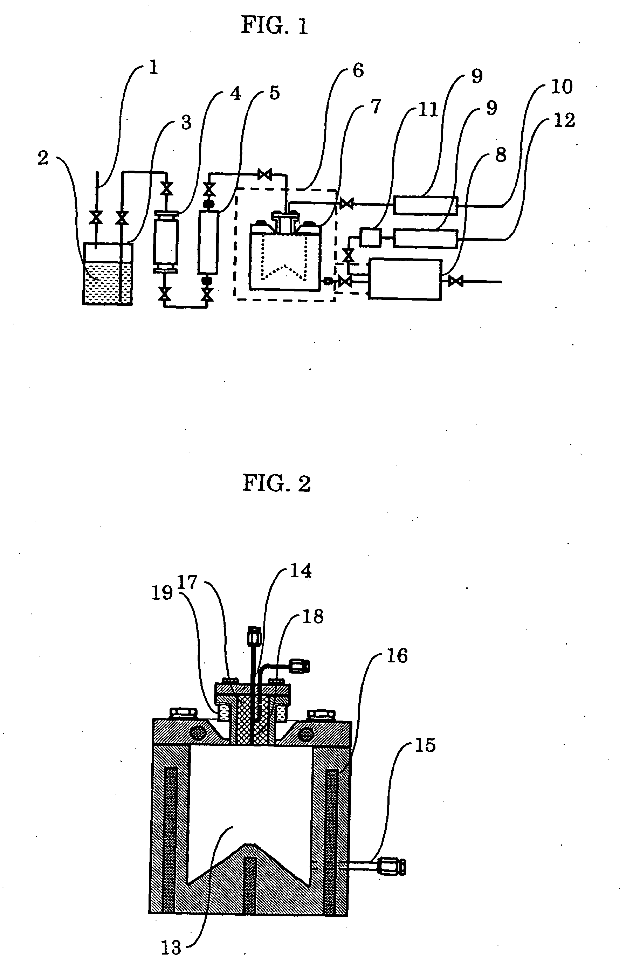

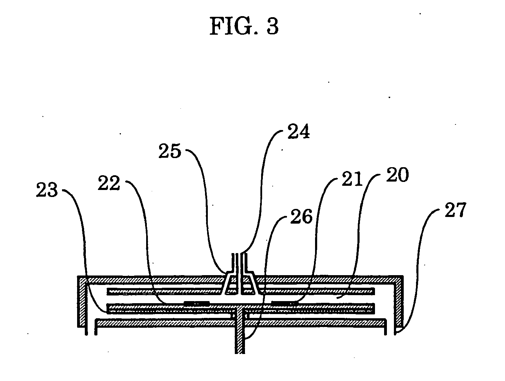

In the invention, the process for forming zinc oxide film of the present invention may be carried out by means of an apparatus for vaporizing and supplying as shown in FIG. 1 and by means of a CVD apparatus as shown in FIG. 3.

In the case of forming zinc oxide film by CVD method, a liquid flow controller 5 such as a liquid mass flow controller or so, a vaporizer 7, and a CVD apparatus 8 are usually installed with optionally attaching a degasser 4 in addition. Further, a gas flow controller 9 and a carrier gas supply pipeline 10 are connected to the vaporizer 7 surrounded by a heat insulator 6. Furthermore, a gas pre-heater 11, an oxidizing agent gas feed line 12 for feeding the oxidizing agent gas such as an oxygen gas, an ozone gas, nitrogen oxides gas, a steam gas or so is also connected to the CVD apparatus 8.

In an occasion of the forming of zinc oxide film, after settling the temperature and the pressure inside of the vaporizer and the CVD apparatus at predetermined values, the material 2 for forming the zinc oxide film is fed from the material container 3 by the pressure of the inert gas to the vaporizer 7, followed by being vaporized, and is further supplied to the CVD apparatus 8. Moreover, the oxygen gas or so is supplied through the oxidizing agent gas feed line 12.

In the present invention, the process for forming the zinc oxide film may be carried out either in accordance with a pressure reduction CVD method, or in accordance with an ordinary pressure CVD method. In the occasion of film-forming, because the material of favorably homogeneous is uniformly vaporized and can be supplied with desired density and desired flow rate, the zinc oxide film having crystal of high quality over various substrates can be obtained.

Additionally, with regard to the vaporizer 7 employed in the process for forming the zinc oxide film of the present invention, it is not particularly limited. However, as shown in FIG. 2, examples include the vaporizer whose material feed portion 14 has a structure that a corrosion resistant synthetic resin 17 such as fluorine-based resin, polyimide-based resin or so; the vaporizer having a coaxial ejection tube 18 for ejecting the liquid material into a vaporizing chamber 13 and for vaporizing consists of an inner tube for ejecting the liquid material and an outer tube for ejecting a carrier gas; or the vaporizer having means 19 for supplying water for cooling along the side surface the CVD material feed portion, etc.

As an example of the above CVD apparatus, FIG. 3 illustrates the apparatus having an annular susceptor 22 for placing a substrate 21 among a reaction chamber 20, a heater 23 for heating the substrate, a material feed pipe 24 for introducing dimethylzinc or diethylzinc into the reaction chamber, a feed pipe 25 for introducing the oxidizing agent gas from outside into the reaction chamber, a rotation axis 26 of the susceptor, and a reaction gas exhaust zone 27.

### EXAMPLES

The present invention shall be explained below in further details with reference to examples, but the present invention shall by no means be restricted by the following examples.

### [Example 1]

### (Preparation of material)

Into a container made of stainless steel (SUS316) having an inner diameter of 8 cm and a height of 10 cm, argon gas was fed through an inert gas feed line and as a result, the inside of the container became to argon atmosphere. Subsequently, dimethylzinc and hexane were placed into the container and mixed there, followed by stirring under ordinary pressure at a temperature of 25 °C and as a result, a material (content of dimethylzinc: 0.5 mol/liter) was prepared.

### (Fabrication of vaporizer)

There was prepared a material feed portion 14 having the passageways in which the inside thereof was constituted of a fluororesin (PFA), and the portion in contact with the outside of the vaporizer was constituted of stainless steel (SUS316). The PFA made portion 17 was a column having an outer diameter of 16 mm and a height of 34.2 mm. The stainless steel outside the column had a thickness of 2.0 mm. Further, an ejection pipe 18 whose leading end is coaxial having an inner pipe as a passageway for the material and an outer pipe as a passageway for a carrier gas was provided. Additionally, a cooling pipe 19 that flew water for cooling along the side face of the material feed portion was equipped as a cooling means for the CVD material feed portion.

There was also prepared, in addition to the foregoing material feed portion 14, as illustrated in FIG. 2, a vaporizer 7 which was made of stainless steel (SUS316) and incorporated with a vaporized gas exhaust port 15, a heater 16. The vaporization chamber was in the form of a column having an inner diameter of 65 mm and a height of 92.5 mm and a protrusion height at the bottom of 27.5 mm. The vaporized gas exhaust port 15 was placed at a height of 15 mm from the bottom of the vaporizer.

### (Fabrication of CVD apparatus)

A annular susceptor 22 (diameter: 260 mm; thickness: 5 mm), a heater 23, a rotation axis 26 of the susceptor, a reaction gas exhaust zone 27 and a cylindrical wall (diameter: 260 mm, thickness: 10 mm) facing to the annular susceptor 22 were provided inside of a reaction container made by quartz (inner diameter: 300 mm; height: 100 mm each about inside dimension). Further, a material feed pipe 24 for introducing dimethylzinc or diethylzinc into the reaction chamber and a gas feed pipe 25 for introducing oxidizing agent gas from the outside into the reaction chamber were provided at the center of the cylindrical wall and as a result, a CVD apparatus as shown in FIG. 3 was fabricated. Additionally, a substrate 21 was settled to be revolved, and to be rotated. Further, a clearance of a reaction chamber 20 in the vertical direction was 15 mm.

### (Fabrication of apparatus for vaporizing and supplying)

Connecting the vaporizer 7 and the CVD apparatus 8 to a degasser 4, a liquid mass flow controller 5, the carrier gas feed line 10, the oxidizing agent gas feed line 12, a gas pre-heater 11, and a gas flow controller 9 and so on; and providing an insulating material 6, an apparatus for vaporizing and supplying as illustrated in FIG. 1 was fabricated. Additionally, the oxidizing agent gas feed line 12 was settled in a manner that the oxidizing agent gas should be added inside of the CVD apparatus. Subsequently, a material container filled with the material and inert gas feed line 1 were connected to the apparatus for vaporizing and supplying.

### (Formation of zinc oxide film)

Using the above material, an apparatus for vaporizing and supplying and the CVD apparatus, a zinc oxide film was formed over a circular silicon substrate having a diameter of 20 mm in accordance with the CVD method in a manner as the following.

Setting the silicon substrate in the susceptor of the CVD apparatus, and after feeding argon gas into the apparatus for vaporizing and supplying and into the CVD apparatus, the atmosphere within the vaporizer was settled to a temperature of 70 °C and to an ordinary pressure, together with maintaining the pressure within the CVD apparatus to 40 kPa, and the substrate to the temperature of 200 °C. Then, by means of the liquid mass flow controller, the above material was fed to the vaporizer with a flow rate of 0.5 g/min, simultaneously feeding argon gas heated to a temperature of 70 °C from the carrier gas feed line into the vaporizer with flow rate of 500 ml/min and as a result, the material was vaporized and supplied to the CVD apparatus. On the other hand, an oxygen gas with a temperature of 30 °C was supplied to the CVD apparatus with a flow rate of 350 milliliter/minute.

### (Evaluation about zinc oxide film)

The zinc oxide film thus obtained was analyzed by means of an atomic force microscope and as a result, it was recognized that the film thickness was 0.10 µ m, and that the zinc oxide film having high purity and being homogeneous was formed. Further, resistibility, hole mobility, and carrier density of the zinc oxide film were as described in Table 1, and it was also recognized that the resultant zinc oxide film had superior characteristics as transparent electro-conductive film.

### [Example 2] (not according to the present invention)

### (Formation of zinc oxide film)

Employing dimethylzinc as the material, and using the same apparatus for vaporizing and supplying, together with the same CVD apparatus as Example 1, a zinc oxide film was formed over a circular silicon substrate having a diameter of 20 mm in accordance with the CVD method.

Setting the silicon substrate in the susceptor of the CVD apparatus, and after feeding argon gas into the apparatus for vaporizing and supplying and into the CVD apparatus, the atmosphere within the vaporizer was settled to a temperature of 50 °C and to an ordinary pressure, together with maintaining the pressure within the CVD apparatus to 40 kPa, and the substrate to the temperature of 200 °C. Then, by means of the liquid mass flow controller, the above material was fed to the vaporizer with a flow rate of 0.01 g/minute, simultaneously feeding argon gas heated to a temperature of 50 °C from the carrier gas feed line into the vaporizer with flow rate of 100 milliliter/minute and as a result, the material was vaporized and supplied to the CVD apparatus for 1 minute. Then, feeding of the material was discontinued and simultaneously, the temperature of the substrate was cooled down to 120 °C, an oxygen gas having a temperature of 30 °C was supplied into the CVD apparatus with a flow rate of 200 milliliter/minute for 1 minute. Subsequently, the supply of the oxygen gas was discontinued and simultaneously, elevating the temperature of the substrate up to 200 °C again, the material was supplied into the CVD apparatus for 1 minute. The above-mentioned operation was repeated 10 times and then, the formation of zinc oxide film was finished.

### (Evaluation about zinc oxide film)

The zinc oxide film thus obtained was analyzed by means of an atomic force microscope and as a result, it was recognized that the film thickness was 0.15 µm, and that the zinc oxide film having high purity and being homogeneous was formed. Further, resistibility, hole mobility, and carrier density of the zinc oxide film were as described in Table 1, and it was also recognized that the resultant zinc oxide film had superior characteristics as transparent electro-conductive film.

### [Example 3] (not according to the present invention)

### (Formation of zinc oxide film)

Employing the same material as Example 1, and using the same apparatus for vaporizing and supplying, together with the same CVD apparatus as Example 1, a zinc oxide film was formed over a circular sapphire substrate having a diameter of 20 mm in accordance with the CVD method.

Setting the silicon substrate in the susceptor of the CVD apparatus, and after feeding argon gas into the apparatus for vaporizing and supplying and into the CVD apparatus, the atmosphere within the vaporizer was settled to a temperature of 70 °C and to an ordinary pressure, together with maintaining the pressure within the CVD apparatus to 40 kPa, and the substrate to the temperature of 200 °C. Then, by means of the liquid mass flow controller, the same material as Example 1 was fed to the vaporizer with a flow rate of 0.5 g/minute, simultaneously feeding aragon gas heated to a temperature of 70 °C from the carrier gas feed line into the vaporizer with flow rate of 500 milliliter/minute and as a result, the material was vaporized and supplied to the CVD apparatus for 1 minute. Then, feeding of the material was discontinued and simultaneously, the temperature of the substrate was cooled down to 120 °C, an oxygen gas having a temperature of 30 °C was supplied into the CVD apparatus with a flow rate of 350 milliliter/minute for 1 minute. Subsequently, the supply of the oxygen gas was discontinued and simultaneously, elevating the temperature of the substrate up to 200 °C again, the material was supplied into the CVD apparatus for 1 minute. The above-mentioned operation was repeated 10 times and then, the formation of zinc oxide film was finished.

### (Evaluation about zinc oxide film)

The zinc oxide film thus obtained was analyzed by means of an atomic force microscope and as a result, it was recognized that the film thickness was 0.18 *µ* m, and that the zinc oxide film having high purity and being homogeneous was formed. Further, resistibility, hole mobility, and carrier density of the zinc oxide film were as described in Table 1, and it was also recognized that the resultant zinc oxide film had superior characteristics as transparent electro-conductive film.

### [Example 4]

### (Formation of zinc oxide film)

The zinc oxide film was formed in the same manner as Example 1, except that diethylzinc was employed instead of dimethylzinc as the material.

### (Evaluation about zinc oxide film)

The zinc oxide film thus obtained was analyzed by means of an atomic force microscope and as a result, it was recognized that the film thickness was 0.11 *µ* m, and that the zinc oxide film having high purity and being homogeneous was formed. Further, resistibility, hole mobility, and carrier density of the zinc oxide film were as described in Table 1, and it was also recognized that the resultant zinc oxide film had superior characteristics as transparent electro-conductive film.

### [Comparative Example 1]

### (Formation of zinc oxide film)

Employing a material (content of zinc acetate: 0.5 mol/liter) prepared by dissolving zinc acetate into hexane, and using the same apparatus for vaporizing and supplying and the same CVD apparatus as Example 1, a zinc oxide film was formed over a circular silicon substrate having a diameter of 20 mm in accordance with the CVD method in a manner as the following.

Setting the silicon substrate in the susceptor of the CVD apparatus, and after feeding argon gas into the apparatus for vaporizing and supplying and into the CVD apparatus, the atmosphere within the vaporizer was settled to a temperature of 70 °C and to an ordinary pressure, together with maintaining the pressure within the CVD apparatus to 40 kPa, and the substrate to the temperature of 200 °C. Then, by means of the liquid mass flow controller, the above material was fed to the vaporizer with a flow rate of 0.5 g/minute, simultaneously feeding argon gas heated to a temperature of 70 °C from the carrier gas feed line into the vaporizer with flow rate of 500 milliliter/minute and as a result, the material was vaporized and supplied to the CVD apparatus. On the other hand, an oxygen gas with a temperature of 30 °C was supplied to the CVD apparatus with a flow rate of 350 milliliter/minute.

### (Evaluation about zinc oxide film)

The zinc oxide film thus obtained was analyzed by means of an atomic force microscope and as a result, it was recognized that the film thickness was 0.11 µ m, and that the zinc oxide film being homogeneous was formed. However, although the resistibility of the zinc oxide film was as practical as Examples such that Table 1 shows, the hole mobility was extremely low as described in Table 1, and the carrier density was extremely high as described in Table 1. Accordingly, any characteristics as the transparent electro-conductive film more superior than the zinc oxide film in Examples was not achieved.

**[Table 1]**

| | Resistivity (Ωcm) | Hole Mobility (cm²/vs) | Carrier Density (cm⁻³) |
|---|---|---|---|
| Example 1 | 8.5×10⁻⁴ | 80 | 2.2×10¹⁷ |
| Example 2* | 1.7×10⁻³ | 94 | 1.5×10¹⁷ |
| Example 3* | 9.4×10⁻⁴ | 86 | 2.1×10¹⁷ |
| Example 4 | 8.2×10⁻⁴ | 81 | 2.3×10¹⁷ |
| Comparative Example 1 | 8.8×10⁻³ | 15 | 9.1×10¹⁷ |

| | | | |
|---|---|---|---|
| * not according to the invention | | | |

### INDUSTRIAL APPLICABILITY

A higher quality and higher purity than both the zinc oxide film formed in accordance with a sputtering process or a sol-gel process and the zinc oxide film formed in accordance with employing solid materials such as zinc acetate, zinc (II) acetylacetonate, bis (2,2,6,6,-tetramethyl-3,5 heptanedionite) zinc each conventionally used and was extremely difficult became realized safely and easily in accordance with the process for forming zinc oxide film of the present invention. The industrial process for film formation without accompanying any danger such as an ignition among the air and an explosion among oxygen provides means for production extremely practical in the viewpoints of environment and safety.

## Claims

1. A process for forming zinc oxide film over a surface of a substrate which comprises a step of vaporizing and supplying a material prepared by dissolving dimethylzinc or diethylzinc into an organic solvent to a chemical vapor deposition apparatus and a step of simultaneously supplying a gas comprising an oxidizing agent gas to the chemical vapor deposition apparatus.

2. The process for forming zinc oxide film according to Claim 1, wherein said oxidizing agent gas is an oxygen gas, an ozone gas, nitrogen oxides gas or a steam gas.

3. The process for forming zinc oxide film according to Claim 1, wherein said substrate is a silicon substrate, a sapphire substrate, a ceramics substrate, a glass substrate, a metal substrate or an alloy substrate.

4. The process for forming zinc oxide film according to Claim 1, wherein said organic solvent is ether, ketone, ester, hydrocarbon or alcohol.

5. The process for forming zinc oxide film according to Claim 1, wherein a content of dimethylzinc or diethylzinc in said material is within a range from 0.1 to 5 mol/liter.

## Patentansprüche

1. Verfahren zur Bildung eines Zinkoxid-Films auf einer Oberfläche eines Substrats welches umfasst, einen Schritt des Verdampfens und Zuführens eines Materials, hergestellt durch Lösen von Dimethylzink oder Diethylzink in einem organischen Lösemittel, an eine Vorrichtung zur chemischen Dampfabscheidung, und einen Schritt des gleichzeitigen Zuführens eines Gases, umfassend ein Oxidationsmittel-Gas, an die Vorrichtung zur chemischen Dampfabscheidung.

2. Verfahren zur Bildung eines Zinkoxid-Films nach Anspruch 1, wobei das Oxidationsmittel-Gas ein Sauerstoff-Gas, ein Ozon-Gas, Stickoxide-Gas oder ein Dampf-Gas ist.

3. Verfahren zur Bildung eines Zinkoxid-Films nach Anspruch 1, wobei das Substrat ein Silizium-Substrat, ein Saphir-Substrat, ein Keramik-Substrat, ein Glas-Substrat, ein Metall-Substrat oder ein Legierungs-Substrat ist.

4. Verfahren zur Bildung eines Zinkoxid-Films nach Anspruch 1, wobei das organische Lösemittel ein Ether, ein Keton, ein Ester, ein Kohlenwasserstoff oder ein Alkohol ist.

5. Verfahren zur Bildung eines Zinkoxid-Films nach Anspruch 1, wobei ein Gehalt an Dimethylzink oder Diethylzink in dem Material innerhalb eines Bereichs von 0,1 bis 5 mol/Liter liegt.

## Revendications

1. Procédé pour former du film d'oxyde de zinc sur une surface d'un substrat qui comprend une étape de vaporisation et de fourniture d'un matériau préparé en dissolvant du diméthylzinc ou du diéthylzinc dans un solvant organique à un appareil de dépôt en phase vapeur par procédé chimique et une étape de fourniture simultanée d'un gaz comprenant un agent d'oxydation gazeux à l'appareil de dépôt en phase vapeur par procédé chimique.

2. Procédé pour former du film d'oxyde de zinc selon la revendication 1, dans lequel ledit agent d'oxydation gazeux est un gaz oxygène, un gaz ozone, du gaz d'oxydes d'azote ou un gaz vapeur.

3. Procédé pour former du film d'oxyde de zinc selon la revendication 1, dans lequel ledit substrat est un substrat de silicium, un substrat de saphir, un substrat de céramique, un substrat de verre, un substrat de métal ou un substrat d'alliage.

4. Procédé pour former du film d'oxyde de zinc selon la revendication 1, dans lequel ledit solvant organique est un éther, une cétone, un ester, un hydrocarbure ou un alcool.

5. Procédé pour former du film d'oxyde de zinc selon la revendication 1, dans lequel une teneur en diméthylzinc ou diéthylzinc dans ledit matériau est comprise dans une gamme allant de 0,1 à 5 mol/litre.
